# EUROPEAN PATENT APPLICATION

(11) **EP 3 399 531 A1**
(43) Date of publication of application: **07.11.2018**
(21) Application number: 18170177.2
(22) Date of filing: 30.04.2018
(51) Int. Cl.: H01G 4/12, H01G 4/18, H01G 4/20

(54) **CAPACITOR WITH DIELECTRIC COMPRISING DOPED BARIUM TITANATE PARTICLES AND EPOXY CONTAINING POYLYMER**

(30) Priority: 01.05.2017 US 201762492781 P
(71) Applicant: Eestor, Inc., Cedar Park, Texas 78613 (US)
(72) Inventor: WEIR, Richard, Cedar Park, TX 78613 (US)
(74) Representative: HGF Limited

(57) **Abstract**

A capacitor includes a dielectric layer including a polymer matrix and ceramic particles dispersed with the polymer matrix. The polymer matrix includes epoxy. The ceramic particles include composition-modified barium titanate ceramic particles. The capacitor may include a plurality of layers. The dielectric layer may have a thickness of 0.1 microns to 100 microns.

## Description

### CROSS-REFERENCE TO RELATED APPLICATIONS

The present application claims priority from U.S. Provisional Patent Application No. 62/492,781, filed May 1, 2017. The entire contents of which are incorporated herein by reference for all purposes.

### FIELD OF THE DISCLOSURE

The present disclosure relates in general to a capacitor including a dielectric layer that includes a polymer matrix and ceramic particles.

### BACKGROUND

Capacitors are used in high voltage applications, such as for utility grid power factor correction. A popular capacitor now used for utility grid power factor correction is made of thin sheets of polypropylene (10 microns) rolled up with thin sheets of metal foil. The relative permittivity of polypropylene is 2.5, which less than desirable. Furthermore, the same capacitors used in the utility grid power factor correction market are also used in the photovoltaic voltage smoothing market.

### SUMMARY

In a particular implementation, a capacitor includes a first electrode, a dielectric layer, and a second electrode. The dielectric layer is disposed between the first electrode and the second electrode, and the dielectric layer includes a polymer matrix including epoxy and ceramic particles dispersed within the polymer matrix. The ceramic particles include a composition-modified barium titanate.

In another particular implementation, a method of forming a capacitor on a substrate includes mixing a polymer precursor solution and ceramic particles to form a mixture, where a volume percent of the ceramic particles to a total volume of the mixture is at least 20%. The method also includes spin coating the mixture on the substrate to form a dielectric layer on the substrate.

### BRIEF DESCRIPTION OF THE DRAWINGS

FIG. 1 is a scanning electron microscope image of a particular embodiment of a dielectric film (or layer) at 8100 times magnification;
FIG. 2 is a scanning electron microscope image of a particular embodiment of a dielectric film (or layer) at 335 times magnification;
FIG. 3 is schematic diagram of a testing system;
FIG. 4 is a graph depicting a voltage discharge curve over time of a dielectric layer; and
FIG. 5 is a diagram illustrating injection molding of a capacitor, according to a particular embodiment.

### DETAILED DESCRIPTION

The following description in combination with the figures is provided to assist in understanding particular aspects of the disclosure. The following discussion focuses on specific implementations and embodiments of the disclosure. This focus is should not be interpreted as a limitation on the scope or applicability of the disclosure.

As used herein, the terms "comprises," "comprising," "includes," "including," "has," "having" or any other variation thereof, are intended to cover a non-exclusive inclusion. For example, a method, article, or apparatus that comprises a list of features is not necessarily limited only to those features but may include other features not expressly listed or inherent to such method, article, or apparatus. Further, unless expressly stated to the contrary "or" refers to an inclusive-or and not to an exclusive-or. For example, a condition A or B is satisfied by any one of the following: A is true (or present) and B is false (or not present), A is false (or not present) and B is true (or present), and both A and B are true (or present).

Also, the use of "a" or "an" is employed to describe elements and components described herein. This description should be read to include one or at least one and the singular also includes the plural, or vice versa, unless it is clear that it is meant otherwise. For example, when a single item is described herein, more than one item may be used in place of a single item. Similarly, where more than one item is described herein, a single item may be substituted for that more than one item.

Unless otherwise defined, all technical and scientific terms used herein have the same meaning as commonly understood by one of ordinary skill in the art to which the subject matter of the disclosure belongs. The materials, methods, and examples are illustrative only and are not intended to be limiting.

Embodiments herein are directed to a capacitor that includes a dielectric layer and electrodes, where the dielectric layer is positioned between the electrodes. The dielectric layer includes a polymer matrix and ceramic particles dispersed within the polymer matrix. The dielectric layer can have a specified thickness and an approximately or substantially uniform distribution of the ceramic particles. Other embodiments herein are directed to a method of forming the capacitor including the dielectric layer. The dielectric layer can be thin and approximately or substantially uniform. For example, the dielectric layer may be formed using a process that limits or avoids formation of air bubble, gaps and cracks. A capacitor fabricated using the methods disclosed herein can have high voltage capability, low leakage current, and highly stable capacitance with voltage. The capacitor can also have excellent operating life, low insulation resistance, and extremely high voltage breakdown capability.

In accordance with an illustrative embodiment, the polymer matrix can include a polymer, or more than one polymer (e.g., a polymer blend or a co-polymer). For example, the polymer matrix can include poly(ethylene terephthalate) (PET), polycarbonate (PC), polypropylene (PP), polyethylene (PE), poly vinyl chloride (PVC), poly(vinylidenefluoride) (PVDF), poly(methyl methacrylate) (PMMA), polyvinyl alcohol (PVA), poly(ethylene napthalate) (PEN), poly(phenylenesulfate) (PPS), poly(N-isopropylacrylamide) (PNIPAM), polyacrylamide (PAM), a polymer formed using pyromellitic dianyhydride (PMDA) (such as a polyimide), poly(2-oxazoline), polyethylenimine (PEI), poly(vinylpyrrolidone) (PVP), a polymer formed using 4,4'-oxydianiline (ODA) (such as a polyimide), epoxy, or another polymer with acceptable electrical characteristics, or a combination thereof. In a particular embodiment, the polymer matrix can include an epoxy resin. The epoxy resin can include bisphenol A epoxy resin, aliphatic epoxy resin, aliphatic glycidylether modified bisphenol A epoxy resin, or a combination thereof. Examples of liquid epoxy resins are D.E.R.™ 317, D.E.R.™ 324, D.E.R.™ 325, D.E.R.™ 330, D.E.R.™ 331, D.E.R.™ 332, or D.E.R.™ 337 (each available from The Dow Chemical Company, Midland, Michigan).The polymer matrix may be cured under vacuum (e.g., to remove solvent) while gradually increasing a curing temperature. For example, the polymer matrix may be cured under a vacuum pressure of about 0.1 MPa while gradually (or in a step-wise fashion) increasing the curing temperature from about 70°C to about 320°C.

In certain embodiments, the polymer matrix may be formed using a polymer or monomer dissolved in a solvent to form a polymer precursor solution. Examples of solvents can include hexafluoroisopropanol (HFIP) or phenol for PET; pyridine for PC; N and N-dimethylformamide for PVDF. Additional solvents, such as acetone, 1,2-dichloroethane, N,N-dimethylacetamide (DMA), dimethyl sulfoxide (DMSO), and tetrahydrofuran (THF), can also, or in the alternative, be used.

In some implementations, the solvent can be selected to provide a specified or target viscosity of the polymer precursor solution, such that for example, the viscosity can be adjusted based on processes used to form the dielectric layer. For example, in spin coating, a particular viscosity or range of viscosities may be used to achieve a specified thickness of the dielectric layer. Varying the ratio of the polymer or monomer to the solvent can change the viscosity. For example, increasing the amount of the solvent used to dissolve the polymer generally reduces the viscosity, and using less solvent generally increases the viscosity of the polymer. The vapor pressure of the solvent may also affect the viscosity.

In accordance with yet another embodiment, a chemical constituent may be added to the polymer, to the monomer, or to the polymer precursor solution to produce the target viscosity or viscosity range. Varying the ratio of the polymer to the chemical constituent may adjust the viscosity of the polymer precursor solution. Examples of the chemical constituent for varying the viscosity of the polymer precursor solution include butyl glycidyl ether, aliphatic glycidyl ether, cresyl glycidyl ether, or ethylhexyl glycidyl ether.

In some embodiments, other chemical constituents may be added to the polymer, to the polymer precursor solution, or to the polymer matrix to improve electrical characteristics of the dielectric layer or the capacitor. For example, a metal acetylacetonate, such as cobalt (III) acetylacetonate may be added to the polymer, to the polymer precursor solution, or to the polymer matric. In such embodiments, presence of the metal acetylacetonate in the polymer matrix (after curing) may improve (e.g., increase) a dielectric constant of the dielectric layer. In such embodiments, the polymer matrix may be cured under vacuum (e.g., to remove solvent) while gradually increasing a curing temperature. For example, the polymer matrix may be cured under a vacuum pressure of about 0.1 MPa while gradually (or in a step-wise fashion) increasing the curing temperature from about 25°C to about 185°C.

In some embodiments, a curing agent may be added to the polymer precursor solution. The curing agent may include an amine, such as polyether diamine, an aliphatic polyether diamine, polyoxypropylenediamine, or the like. Thus, in some examples, the polymer precursor solution is a mixture including one or more polymers (or monomers), one or more solvents, one or more curing agents, one or more viscosity modifiers, other chemical constituents, or a combination thereof.

According to at least one embodiment, the dielectric layer includesceramic particles dispersed within the polymer matrix. The ceramic particles may make up at least 20 vol%, at least 30 vol%, at least 40 vol%, or at least 50 vol% of a total volume of the polymer matrix and the ceramic particles (or a total volume of a mixture including the polymer precursor solution and the ceramic particles). In some embodiments, the ceramic particles make up not greater than 95 vol%, no greater than 90 vol%, or no greater than 85 vol% of a total volume of the ceramic particles and the polymer matrix (or the total volume of the mixture including the polymer precursor solution and the ceramic particles). For example, the ceramic particles may make up in a range of 20 vol% to 95 vol%, in a range of 30 vol% to 90 vol%, or in a range of 40 vol% to 85 vol% of a total volume of the ceramic particles and the polymer matrix (or the total volume of the mixture including the polymer precursor solution and the ceramic particles). The ceramic particles can include a composition-modified barium titanate (CMBT). In a particular embodiment, the CMBT has a formula (Ba_{1-α-µ-ν}A_{µ}D_{ν}Ca_{α})[Ti_{1-x-δ-µ'-ν'}Mn_{δ}A'_{µ'}D'_{ν'}Zrₓ]_{z}O₃, where A=Ag or La, A'=Dy, Er, Ho, Y, Yb, or Ga; D=Nd, Pr, Sm, or Gd; D'=Nb or Mo; 0.10 ≤ x ≤ 0.25; 0 ≤ µ ≤ 0.01, 0 ≤µ'≤ 0.01, 0 ≤v ≤ 0.01, 0 ≤ v' ≤ 0.01, 0 ≤ δ ≤ 0.01, 0.995 ≤ z ≤ 1, and 0 ≤ α ≤ 0.05. For example, in one embodiment, the CMBT has the constituents listed in the following table 1.

**TABLE 1**

| Metal element | Atom fraction | Atomic Wt. | Product | Wt % |
|---|---|---|---|---|
| Ba | 0.9575 | 137.327 | 131.5 | 98.53 |
| Ca | 0.0400 | 40.078 | 1.60 | 1.20 |
| Nd | 0.0025 | 144.242 | 0.36 | 0.27 |
| Total | 1.00 | | | 100 |
| | | | | |
| Ti | 0.8150 | 47.867 | 39.01 | 69.92 |
| Zr | 0.1800 | 91.224 | 16.42 | 29.43 |
| Mn | 0.0025 | 54.93804 | 0.14 | 0.25 |
| Y | 0.0025 | 88.9058 | 0.22 | 0.39 |
| Total | 1.00 | | | 100 |

In certain instances, Lanthanum (La) and Tin (Sn) can be used in the CMBT. The processes and materials that can be used to fabricate the CMBT powder can be found in U.S. Pat. No. 7,914,755 B2 by Richard D. Weir et al. and in U.S. Pat. Pub. No. 2012/0212987 A1 by Richard D. Weir et al., the entire content of each of which is incorporated herein by reference.

According to an embodiment, the CMBT powder can be coated with an organic material to promote dispersion in the polymer matrix. For example, the organic material can include an amphiphilic agent, such as a trialkoxysilane. In this example, an alkyl group of the trialkoxysilanecan include, for example, 1 to 5 carbon atoms. In a particular embodiment, a thin layer of coating of the trialkoxysilane may be formed. Examples of the trialkoxysilane include, but are not limited to, amino propyl triethoxysilane, vinyl benzyl amino ethyl amino propyl trimethoxysilane, methacryloxypropyl trimethoxysilane, glycidoxypropyl trimethoxysilane, phenyl trimethoxysilane, or N-(2-aminoethyl)-3-aminopropyltrimethoxysilane. The amphiphilic agent can be chosen such that the organic group matches (e.g., is chemically compatible with) the polymer into which the ceramic particles are being dispersed. Alternatively, the trialkoxysilane functional group can be substituted with a phosphonic, sulfonic, or carbonic acid group.

In a particular embodiment, the CMBT powder can be coated with an amphiphilic agent, such as a silane, as follows:
1. In a 250mL beaker, combine 100% ethanol and distilled water in a ratio of 15:1 to 20:1, such as combining 154.4mL of 100% ethanol with 8.125mL of DI water.
2. Place the beaker on a hot plate with a mixer impeller blade in the solution.
3. Turn up speed dial as fast as possible without splashing or having the solution touch the top of the beaker.
4. Add 2 to 5 mL of silane solution, such as 3.25mL.
5. Set the heat control around 190 °C to 225 °C, such as 215 °C on the heating stand and ensure that this temperature maintains a solution at a desired temperature of 60 °C to 80 °C, such as 70 °C. Frequently check temperature with a thermocouple and adjust heat plate as desired.
6. Once the desired solution temperature is maintained, slowly add 50 g to 80 g, such as 65 g, of CMBT powder into the solution.
7. Allow the solution to remain at the desired solution temperature while mixing for 0.5 hours to 1.5 hours, such as 1 hour, or until approximately 2 cm to 4 cm, such as 2.5 cm liquid remains. Be careful not to cook or boil to complete dryness.
8. Place the powder like sludge into the vacuum oven at 100 °C to 140 °C, such as 120 °C, at 5inches (12.5 cm) water column (WC) for 1 hour or until the silane is complete cured.
9. Break up the powder and distribute the silane evenly between 4 (50mL) centrifuge tubes.
10. Add 35 mL to 45 mL, such as 40 mL, of ethanol to each tube. Ensure that each tube has approximately the same volume.
11. Shake the tubes vigorously.
12. Centrifuge the tubes for 10 minutes to 30 minutes, such as 20 minutes at 2.0 relative centrifuge force (rcf) to 5.0 rcf, such as 3rcf.
13. Pour off the ethanol from the top.
14. Using a spatula or other similar tool to break up the solid at the bottom.
15. Add 35 mL to 45 mL, such as 40 mL, of ethanol to each tube. Ensure that each tube has approximately the same volume.
16. Shake the tubes vigorously.
17. Centrifuge the tubes for 10 minutes to 30 minutes, such as 20 minutes at 2.0 rcf to 5.0 rcf, such as 3 rcf.
18. Pour off the ethanol from the top.
19. Using a spatula or other similar tool to break up the solid at the bottom.
20. Place the solids in the vacuum oven overnight at 70°C to 100 °C, such as 90 °C, with air flowing (such as 5 inches (12.5 cm) WC).
21. Pestle grind the powder and place back in the vacuum oven at 70°C to 100 °C, such as 90 °C, with air flowing (such as 5inches (12.5 cm) WC) daily until completely dry and ground into a fine powder (at least 3-4 days).

According to an embodiment, the coated CMBT powder is dispersed into the polymer precursor solution through, for example, high turbulence mixing. The following is an example of high turbulent mixing, and epoxy is used as an exemplary polymer for illustration purpose. Other polymers, such as polymers described above, can be used to form a mixture with the coated CMBT powder. The high turbulent mixing system can be an ultrasonic unit or a unit that can apply turbulent vibrational mixing.
1. Place mixing container that is used by the high turbulent mixing system on a scale and then zero out on the scale; then weigh specified amount of the liquid epoxy resin into mixing container.
2. Place plastic weigh boat on scale and zero out the scale, and weigh a specified amount of composition-modified barium titanate powders to add to mixing container.
3. Use auto-pipette to add specified amount of constituent chemicals to the mixing container.
4. Hand mix solution then set intensity to 40% to 70%, such as 60%, on the high turbulent mixing system and mix for 10 min to 1 hour, such as 30 minutes.
5. Remove mixing container from high turbulent mixing system and remove cover to prepare for degassing. Set the degassing intensity to 5% to 20% (depending on viscosity, such as 12%) and degas for 45 min to 150 min, such as 105 minutes, at desired vacuum. Note: the degassing process is where the container is sealed and a vacuum is created to assist in removing the air bubbles from the polymer solution.

In an embodiment, the mixture including the polymer precursor solution and the ceramic particles are formed into the dielectric layer. Different processes may be used to dispose a polymer dielectric layer on a substrate, such as a screen printing process, a tape or sheet casting method, or spin coating. When the mixture of the polymer precursor solution and the ceramic particles includes 20vol% or more filler (such as the ceramic particles), a dielectric layer formed using a screen printing process or a tape or sheet casting method may take longer to dry (relative to a dielectric layer formed using a spin coating process). Additionally, dielectric layers formed using a screen printing process or a tape or sheet casting method may have a less uniform distribution of ceramic particles than dielectric layers formed using spin coating processes.

A spin coating process may be used to form a dielectric layer by depositing a small puddle of a polymer resin fluid (including the polymer precursor solution and the ceramic particles) onto the center of a substrate, static or spinning at a low speed (e.g. not greater than 500 rpm), and then spinning the substrate at high speed (e.g. 3000 rpm). Centripetal acceleration can cause the polymer resin fluid to spread to, and eventually off, the edge of the substrate leaving a thin film of the polymer resin fluid on the surface. The nature of the polymer resin fluid (viscosity, drying rate, percent solids, surface tension, etc.) and the parameters chosen for the spin process can affect final film thickness and other properties of the dielectric layer. Factors such as final rotational speed, acceleration, and fume exhaust contribute to the properties of coated film.

According to an embodiment, the spin coating process is used to form the dielectric layer including the polymer matrix and the ceramic particles. The spin coating process may be controlled by tuning the parameters of the process to form the dielectric layer with specified uniformity, thickness, and other properties. A subtle variation in the parameters of the spin coating process can result in drastic variations in the coated film. Certain effects of these variations are described in embodiments herein.

In an embodiment, the spin coating process includes dispensing a portion of the mixture of the polymer precursor solution and the ceramic particles onto the substrate surface. The substrate can be held rigidly onto the spin coater. In an embodiment, the substrate includes flexible material, such as a metal foil. In another instance, the substrate includes a rigid material, such as a metal coated glass or solvent resistant plastic. In a further embodiment, the mixture is injected onto the substrate. The amount of mixture injected can be dependent on the substrate size and shape. In a particular embodiment, the minimum amount of the mixture needed to cover the substrate to the desired thickness is dispensed. Excess fluid may be flung from the edges of the substrate during a subsequent action.

In accordance with an embodiment, the mixture is dispensed using a static dispense, dynamic dispense, or a combination thereof. According to an embodiment, static dispense includes depositing a portion of the mixture on or near the center of the substrate. The substrate can be static, such as having a spin speed of 0 rpm. The amount of the mixture dispensed can range from 1 to 10 cc or higher than 10 cc, depending on the viscosity of the mixture, the size of the substrate to be coated, or any of the forgoing. For example, a greater amount of the mixture may be dispensed onto a larger substrate or may be used for a mixture with higher viscosity, such that full coverage of the substrate during the spin action occurs.

In a particular embodiment, the spin coating process includes dynamic dispense. Dynamic dispense can include dispensing the mixture while the substrate is turning at a low speed. For instance, the speed may be in a range of 100 rpm to 500 rpm. Dynamic dispense may allow a smaller amount of the mixture, with respect to the static dispense process, to be used for full coverage of the substrate, because the initial low speed of the substrate may help to spread the mixture over the substrate and reduce the amount needed to wet the entire surface of the substrate. Dynamic dispense may result in less waste of the mixture including the polymer precursor solution and the ceramic particles. Dynamic dispense can also help to eliminate voids that may form when the mixture or substrate has poor wetting abilities.

According to one embodiment, the spin coating process includes a spin action. The spin can include acceleration, such that at least a portion of the spin coating process is performed at a relatively high spin speed relative to the spin speed during the dynamic dispense. The spin speed can range from 1000 rpm to 6000 rpm, depending on the properties of the mixture as well as the substrate. For example, the spin speed can be in a range of 1500 rpm to 3500 rpm. In another embodiment, the spin speed is higher than 3500 rpm. Varying the spin speed can change the final thickness of the dielectric layer. For example, spinning at a higher speed may help to reduce the thickness if a thinner film is desired. According to another embodiment, spinning continues for a duration lasting between 10 seconds and several minutes, such as from 10 seconds to 5 minutes, depending on the properties of the mixture, the specified thickness of the coated film, the properties of the substrate, or any combination of the forgoing.

In a particular embodiment, the spin action includes a spin speed ramp-up profile, such that the spin action has different speeds with each having different processing times. For example, the spin speed can be 1600 rpm to 3200 rpm for a certain period of time, and then change to not greater than 2500 rpm (e.g. 1200 rpm to 2000 rpm) for another period of time. In a particular example, the first spin speed lasts for less than 20 seconds, for example, 1 second to 18 seconds. In this particular example, the second spin speed lasts for less than 2 minutes, such as 30 seconds to 2 minutes.

During the spinning action, the solvent, if used, may evaporate leaving a thin film including the polymer and CMBT ceramic particles that is stretched by the angular motion. The combination of spin speed and time selected for the spinning action may be used to control the final thickness of the dielectric layer. For example, increasing the spin speeds, the spin times, or both, produces thinner dielectric layers.

The spin speed of the substrate (rpm) affects the magnitude of radial (centrifugal) force applied to the resin (i.e., the polymer and CMBT ceramic particles) as well as the velocity and characteristic turbulence of the air immediately above the resin. To some extent, the spin speed of the spin process may determine the final thickness of the dielectric layer. In a particular embodiment, the thickness of the dielectric layer (also referred to herein as film thickness) may be changed by varying the spin speed. For example, a variation of ±50 rpm can cause a resulting thickness change of 10%. Film thickness can also be a balance between the force applied to shear the resin towards the edge of the substrate and the drying rate which affects the viscosity of the resin. As the resin dries, the viscosity increases until the radial force of the spin process can no longer appreciably move the resin over the surface. At this point, the thickness may not decrease significantly with increased spin time. The acceleration of the substrate towards the final spin speed can also affect properties of the dielectric layer and it may be desired to accurately control acceleration to allow the resin to have linear expansion during the initial spin process.

The spin process can provide a radial (outward) force to the resin, and acceleration can provide a twisting force to the resin. This twisting aids in the dispersal of the resin around topography that might otherwise shadow portions of the substrate from the resin. Acceleration of spinners is programmable with a resolution of 1 rpm/second. In operation the spin motor can accelerate (or decelerate) in a linear ramp to the final spin speed. It may also be important that the airflow and associated turbulence above the substrate itself be minimized, or at least held constant, during the spin process.

In yet another embodiment, the spin coating process includes drying to eliminate excess solvents from the resulting dielectric layer. The drying action can be performed after spinning, which may help to further dry the dielectric layer without substantially reducing the thickness of the layer. This can be advantageous for thick dielectric layers since long drying times may be necessary to increase the physical stability of the dielectric layer before handling. Without the drying step, problems may occur during handling, for example, the dielectric layer may pour off the side of the substrate when being removed from the spin bowl. In another embodiment, a moderate spin speed, such as 25% of the speed used for high speed spin, may be used to aid in drying the dielectric layer without significantly changing the thickness of the dielectric layer.

In accordance with an embodiment, the spin coating process includes curing in the range of 70 degrees centigrade to 140 degrees centigrade. Curing may be performed after the spinning action to completely remove the remaining solvent to cure the resin. In an instance, curing may be performed in lieu of drying, particularly when the resin includes the chemical constituent disclosed herein. The curing action can include curing in vacuum, in an oven, or in vacuum oven. Curing time, curing temperature, and level of vacuum process can affect curing of the resin including the polymer precursor solution and the ceramic particles and can be chosen based on the properties of the polymer.

As disclosed herein, the thickness of the dielectric layer can be adjusted by changing one or any combination of the parameters disclosed herein. In an embodiment, the thickness of the dielectric layer is at least 0.1µm, such that sufficient insulation can be provided to adjacent electrodes. For example, the thickness of the dielectric layer can be at least 0.15µm, at least 0.28µm, or even higher. The thickness may be selected based on the desirable properties of the capacitor. In an example, the thickness can be at least 0.6µm, at least 1 µm, at least 3 µm, or at least 7 µm. In other embodiments, thickness is not greater than 100 µm, as thinner dielectric layer may increase capacitance of the capacitor due to inverse relation between the thickness of the dielectric layer and the capacitance. For instance, the thickness of the dielectric layers may not be greater than 90µm, 80µm, or 70µm. In a particular embodiment, the thickness of the dielectric layer is not greater than 50µm. The thickness of the dielectric layer can be in a range including any of the minimum to maximum values noted above. For example, the thickness can be in a range of 0.1µm to 100µm, 0.28 µm to 90 µm, or 0.6µm to 80µm. In a particular embodiment, the thickness is in a range of 3 µm to 50 µm. For example, the thickness may be in a range of 3µm to 16µm.

In accordance with one embodiment, the dielectric layer has a particular dielectric strength. For example, the dielectric strengths can be at least 30 V/µm, at least 40 V/µm, at least 45 V/µm, or 50 V/µm. In another embodiment, the dielectric strength is not greater than 100 V/µm, such as not greater than 95 V/µm, not greater than 91 V/µm, or not greater than 85 V/µm. The dielectric strength can be within any of the minimum values to maximum values noted above, such as 30 V/µm to 100 V/µm. In a particular embodiment, the dielectric strength is in a range of 40 V/µm to 85 V/µm.

According to another embodiment, the dielectric layer has a specified permittivity relative to permittivity of vacuum (also referred to as "relative permittivity"). For example, the relative permittivity of the dielectric layer can be at least 30, at least 40, at least 50, or even at least 60,. The higher values of relative permittivity, such as 50and higher, may be achieved by using a relatively more polar polymer, such as a relatively more polar epoxy. In a particular embodiment, the relative permittivity is in a range of 30 to 60.

After reading this disclosure, a skilled artisan would understand that single dielectric layers formed in accordance with the spin coating process can be combined and used to create a multilayer capacitor. For example, the layers can be stacked on top of each other, and the spin coating process can be repeated until the desired number of layers has been formed to produce the desired capacitance. In an embodiment, the capacitor includes a plurality of dielectric layers each having a thickness in a range of 3µm to 100µm and each having a dielectric strength greater than 40 V/µm. The features of the capacitors include a solid state polymer based capacitor where there is no liquid electrolyte, the energy is stored in the electric field, and no charging current flows through the capacitor. The relative permittivity (capacitance) of the CMBT powders increases with applied voltage. The capacitor may be sealed into a plastic housing or seal that is hydrophobic to prevent or limit degradation due to moisture. The plastic housing provides also improves resistance to shock and vibration. Furthermore, high insulation resistance is provided by the CMBT powder. When used, a coating is applied to the CMBT powders to assist in providing a seal that limits or prevents degradation. The coating also assists in providing an extremely low leakage current. Still further, low product cost due to the low cost of the constituents and production equipment can allow for cost-effective manufacturing. The capacitor can include a large number of layers in a stack and provides a high capacitance with high voltage and high resistance.

A capacitor as described herein can be used in place of a conventional aluminum electrolytic capacitor that fails to meet all of the features as seen with the novel capacitor. The disclosed capacitor is well suited for high voltage applications, such as the utility grid power factor correction market due to the small size, long operational life, and cost. The capacitor dielectric can have a relative permittivity of about 50. A popular capacitor now used for utility grid power factor correction is made of thin sheets of polypropylene (10 microns) rolled up with thin sheets of metal foil. The relative permittivity of polypropylene is 2.5, which is 5%, or potentially even less, than the relative permittivity for a capacitor as described herein. Furthermore, the same capacitors used in the utility grid power factor correction market are also used in the photovoltaic voltage smoothing market. Accordingly, capacitors as described herein can be useful in a variety of electrical utility based applications.

Many different aspects and embodiments are possible. Some of those aspects and embodiments are described herein. After reading this specification, skilled artisans will appreciate that those aspects and embodiments are only illustrative and do not limit the scope of the present invention. Embodiments may be in accordance with any one or more of the items as listed below.
Item 1. A capacitor comprising:
   a first electrode;
   a dielectric layer comprising:
   a polymer matrix including epoxy; and
   ceramic particles dispersed within the polymer matrix and comprising a composition-modified barium titanate, and
   a second electrode,
   wherein the dielectric layer is disposed between the first electrode and the second electrode.
Item 2. The capacitor of item 1, wherein the composition-modified barium titanate comprises (Ba_{1-α-µ-ν}A_{µ}D_{ν}Ca_{α})[Ti_{1-x-δ-µ'-ν'}Mn_{δ}A'_{µ'}D'_{ν'}Zrₓ]_{z}O₃, where A=Ag or La, A'=Dy, Er, Ho, Y, Yb, or Ga; D=Nd, Pr, Sm, or Gd; D'=Nb or Mo; 0.10 ≤ x ≤ 0.25; 0 ≤ µ ≤ 0.01, 0 ≤µ'≤ 0.01, 0 ≤ν≤ 0.01, 0 ≤ ν' ≤ 0.01, 0 ≤ δ ≤ 0.01, 0.995 ≤ z ≤ 1, and 0 ≤ α ≤ 0.05.
Item 3. The capacitor of item 1, wherein the ceramic particles are coated with anamphiphilic agent.
Item 4. The capacitor of item 1, wherein the dielectric layer has a thickness in a range of 0.1 microns to 100 microns.
Item 5. The capacitor of item 1, wherein the dielectric layer has a relative permittivity of at least 30.
Item 6. A capacitor comprising:
   at least one dielectric layer comprising a polymer matrix and ceramic particles dispersed within the polymer matrix, wherein the polymer matrix comprises epoxy;
   wherein the dielectric layer has a relative permittivity of at least 30.
Item 7. The capacitor of item 6, wherein the dielectric layer has a thickness in a range of 0.1 microns to 100 microns.
Item 8. The capacitor of item 6, wherein the dielectric layer has a thickness in a range of 3 microns to 30 microns.
Item 9. The capacitor of item 6, wherein the ceramic particles make up at least 20 vol%, at least 30 vol%, at least 40 vol%, or at least 50 vol% of a total volume of the polymer matrix and the ceramic particles.
Item 10. The capacitor of item 6, wherein the ceramic particles make up not greater than 95 vol%, no greater than 90 vol%, or no greater than 85 vol% of a total volume of the ceramic particles and the polymer matrix.
Item 11. The capacitor of item 6, wherein the ceramic particles make up in a range of 20 vol% to 95 vol%, in a range of 30 vol% to 90 vol%, or in a range of 40 vol% to 85 vol% of a total volume of the ceramic particles and the polymer matrix.
Item 12. The capacitor of item 6, wherein the relative permittivity is at least 50 or at least 60.
Item 13. A method of forming a capacitor on a substrate, the method comprising:
providing a mixture including a polymer precursor solution and ceramic particles,
   wherein a volume percent of the ceramic particles to a total volume of the mixture is at least 20%; and
   spin coating the mixture on the substrate to form the dielectric layer on the substrate.
Item 14. The method of item 13, wherein the polymer precursor solution comprises epoxy.
Item 15. The method of item 13 further comprising curing the mixture to form the dielectric layer.
Item 16. The method of items 15, wherein the mixture is cured at a temperature in a range of 70 °C to 140 °C.
Item 17. The method of item 13, wherein spin coating comprises dispensing the mixture on the substrate while the substrate is spinning at a speed in a range of 0 rpm to 500 rpm.
Item 18. The method of item 17, wherein spin coating further comprises spinning the substrate at a speed in a range of 1000 rpm to 6000 rpm after dispensing.
Item 19. The method of item 13, wherein the dielectric layer has a thickness in a range of 0.1 microns to 100 microns.
Item 20. The method of item 13, wherein the dielectric layer has a relative permittivity of at least 30, at least 40, at least 50, or at least 60.

### EXAMPLE

The Example is given by way of illustration only and does not limit the scope of the present invention as defined in the appended claims. The Example demonstrates the formation of a capacitor including a dielectric layer in accordance with an illustrative, non-limiting embodiment.

A particular spin coating process is described as follows. After reading this disclosure, a skilled artisan would understand variation of the parameters of the spin coating process disclosed herein can be used to achieve certain properties of the dielectric layer and such modifications are within the scope of embodiments herein.
- A mixture including 50% to 80% by volume CMBT particles, such as 70% by volume, and 20% to 50%, such as 30%, by volume polymer precursor solution was spin coated onto a substrate including a 10 µm smooth copper film. The thickness and the material of the substrate can be changed as desired.
- The spin coating process used a spin profile including a spin speed of 100 rpm to 300 rpm, such as 200 rpm, for 3 to 10 seconds, such as 6 seconds, during which the mixture was injected from a solution dispenser at a pressure of 10 PSI to 20 PSI, such as 13 PSI.
- At the end of the initial spin time, a back vacuum was applied to the solution dispenser to assist in keeping any additional drops of the mixture from falling.
- The spin speed was then increased to between 2200 rpm to 3000 rpm, such as 2800 rpm, for 1 to 8seconds, such as 3 seconds.
- Then, the spin speed was decreased to between 1000 rpm to 2000 rpm, such as 1500 rpm, for 0.5 minutes to 2 minutes, such as 1 minute.
- The layer formed by the spin coating process was then removed from the spin coater and taken to a vacuum oven for final curing.
- The layer formed by the spin coating process was processed in the vacuum oven using the following temperature/vacuum profile:
   1) 70 °C to 90 °C, such as 80 °C, for 30 minutes to 90 minutes, such as 60 minutes;
   2) 100 °C to 140 °C, such as 125 °C, for 2 to 5 hours, such as 3 hours.

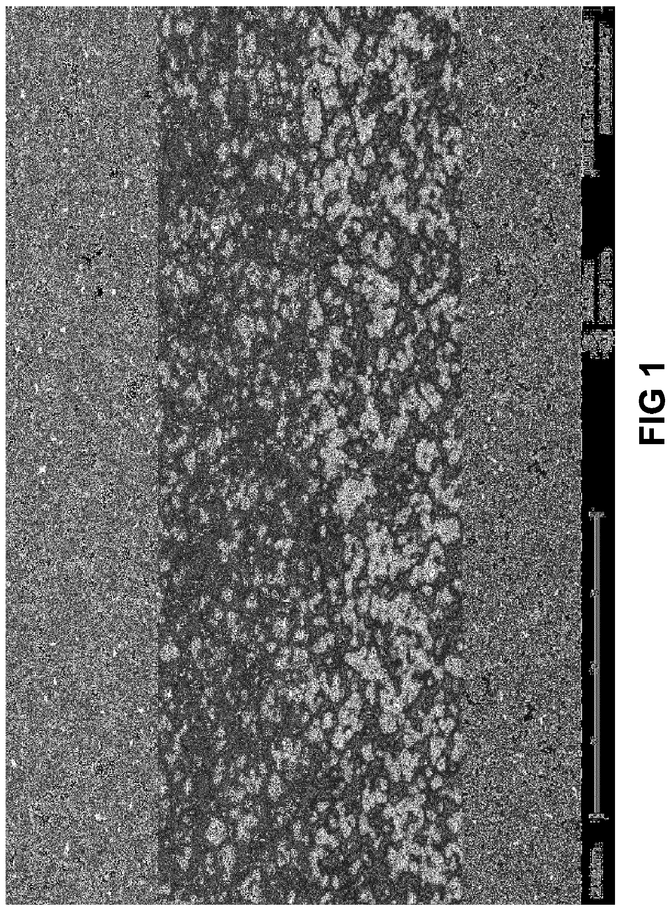

FIGs. 1 to 2 include scanning electron microscope (SEM) images of dielectric films formed in accordance with embodiments herein. The images indicate that both of the spin coated dielectric films were a contiguous smooth film without any flaws or breaks. The dielectric films shown in the images had a thickness of 10 microns.

FIG. 1 includes a SEM picture with 8100 times magnification. The dielectric layer included the polymer matrix and the coated CMBT ceramic particles.

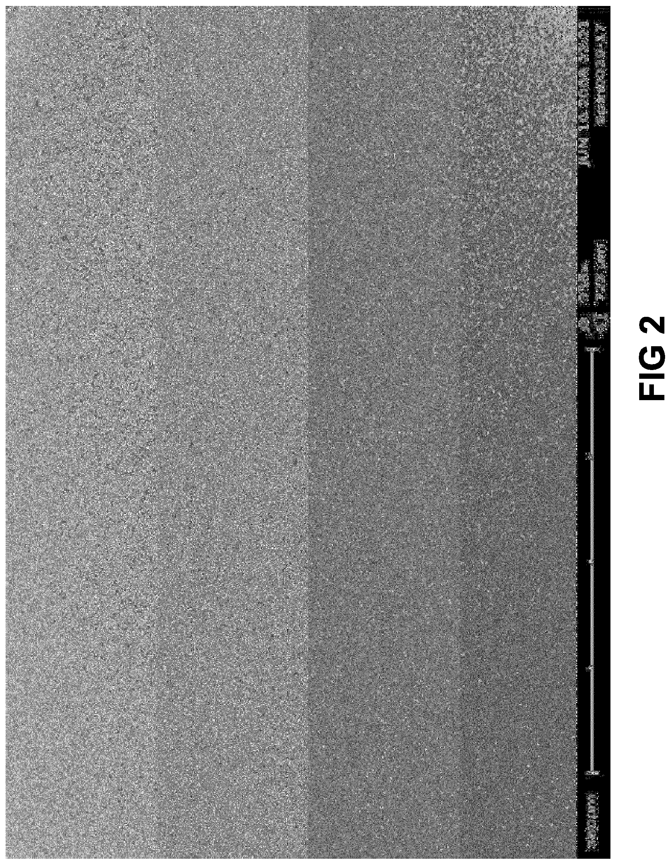

FIG. 2 includes a SEM picture with 335 times magnification. The dielectric layer included the polymer matrix and the coated CMBT ceramic particles.

The formed dielectric layer was tested on a capacitance vs. voltage test system. The capacitance vs. voltage test system is indicated in the following schematic. The capacitor indicated on the schematic includes the dielectric layer being tested.

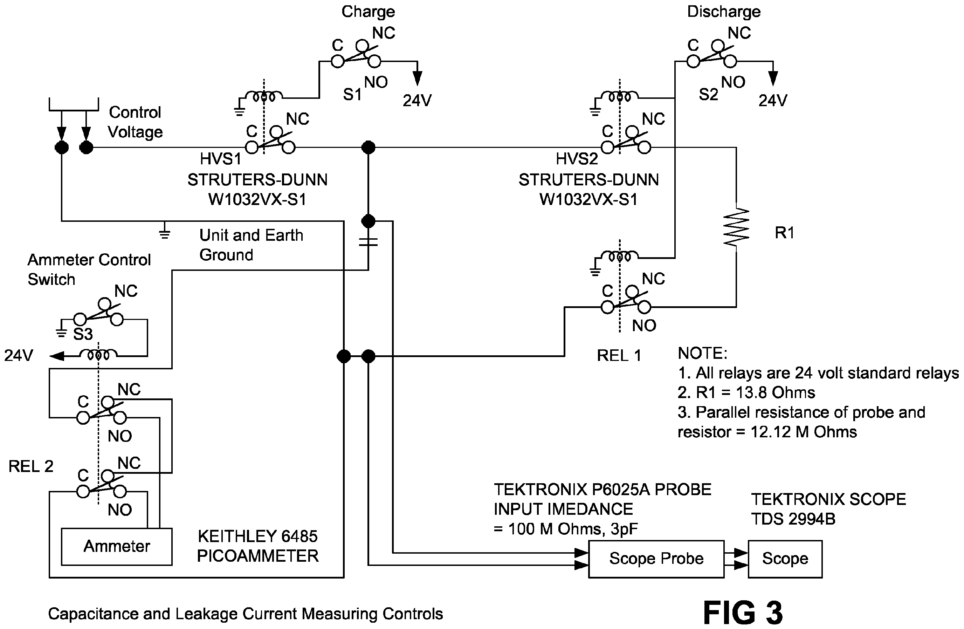

First the capacitor including the dielectric layer was installed into a test jig that connects to an anode of the capacitor and to a cathode of the capacitor, as indicated in FIG. 3. A Stanford Research programmable power supply was set to a voltage of 390V dc. Then R1 was switched to the active mode. Then the Stanford Research power supply is switched off and the decay voltage was tracked on a Tektronix scope.

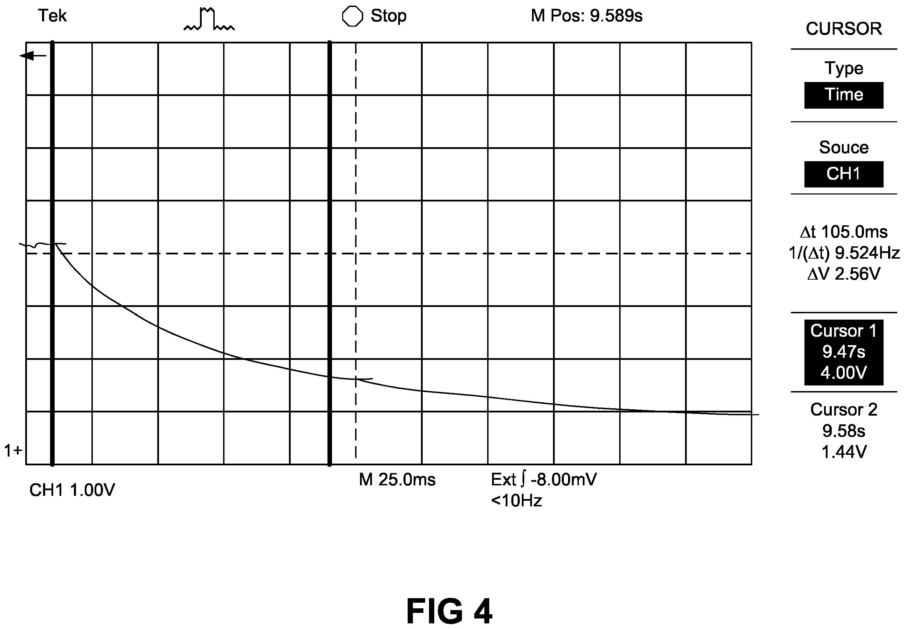

In the graph illustrated in FIG. 4, the vertical lines represent voltage readings of the discharge voltage at specific times. The initial vertical line indicates the initial voltage (4.0 volts dc) before the discharge has started. The discharge curve is created by the discharge resistor (R1 in FIG. 3) and the system resistance (12.12 x 10⁶ ohms in this example). Give the discharge curve and known resistance values, the equation of RC = τ, where R is resistance, C is capacitance, and τ is the discharge time constant (also referred to as the RC time constant) can be used to calculate the capacitance across the dielectric layer. Thus, the capacitance is τ divided by R. Based on the discharge curve, τ corresponds to about 0.37 times the initial voltage of 4.0 volts, which is 1.48 volts. The second vertical line in FIG. 4 is set at 1.4 volts, which was the closest to the 1.48 volts that was available. The time corresponding to the second vertical line (and therefore approximately equal to τ) is about 105 milliseconds. Solving for capacitance based on a value of 105 milliseconds for τ provides a capacitance across the dielectric layer of about 9 nanofarads.

The size of the dielectric layer was 14.1 microns thick and in a shape of a one inch (2.5 cm) diameter circle. The leakage current was 36 nanoamps. The insulation resistance of the dielectric layer can be calculated as the applied voltage (i.e., 390 V in this example) divided by the leakage current (36 nanoamps in this example). Therefore, the insulation resistance was 1x10¹⁰ ohms (or about 10 gigaohms).

Particular embodiments herein are related to capacitor including a plurality of layers. The capacitor includes more than one layer of the dielectric films. Each of the dielectric layers may have the thickness disclosed herein, for example, in a range of 3µm to 100µm. The capacitor may include more than one conductive layer. The conductive layer can include a metal, such as iron, nickel, chromium, aluminum, or a combination thereof. In another embodiment, other metal materials are used for forming the conductive layer. In a particular embodiment, the conductive layer includes an alloy including the more than one metal disclosed herein. For example, the conductive layer can include stainless steel. In another particular embodiment, the capacitor includes at least one layer including a noble metal. Examples of the noble metals include ruthenium, rhodium, palladium, silver, osmium, iridium, gold, and platinum. For instance, the capacitor can include at least one layer including gold.

The dielectric layers may be disposed between the conductive layers. In a particular embodiment, the layer including the noble metal, such as the gold layer, acts as a floating node of the capacitor. According to another embodiment, the gold layer is formed by a sputtering process.

According to an embodiment, the conductive layer, noble metal layers, or both, has a thickness in a range of 5µm to 20µm, such as 7µm to 18µm or 9µm to 15µm.

According to another embodiment, the dielectric layers, conductive layers, and noble metal layers are stacked, e.g., in a parallel mode, such that the total capacitance of the stack corresponds to a sum of the capacitances of the layers in the stack. For example, if there are 1000 layers in the stack and the capacitance of each layer is 10 nanofarads, then the capacitance of the stack would be 10 microfarads or 1000 time the capacitance of each layer.

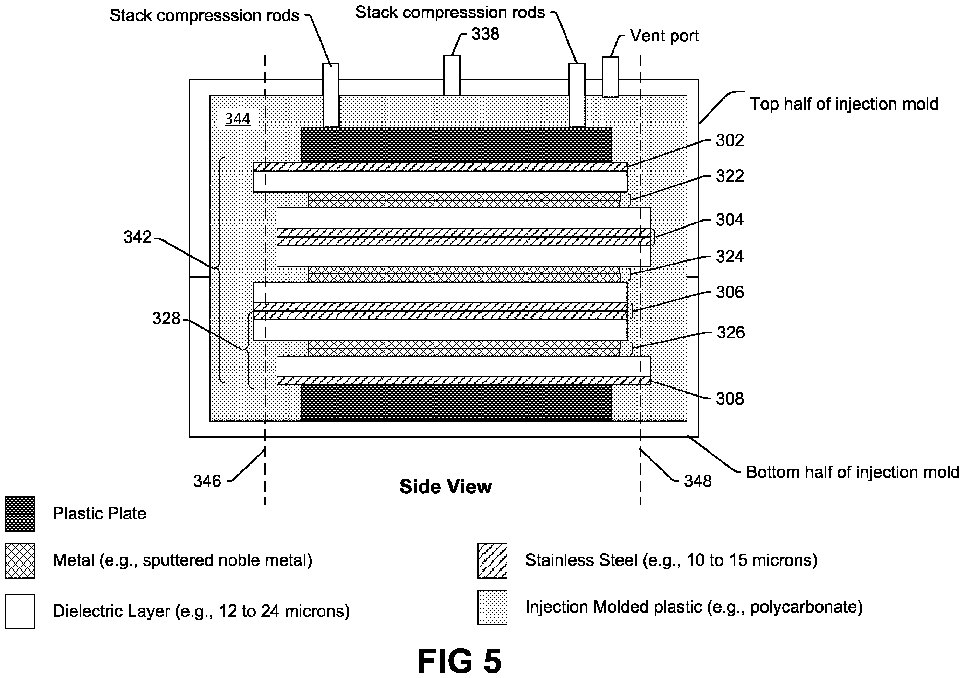

FIG 5. includes a schematic illustrating a particular stacking process. Referring to FIG. 5, plastic injection ports 338 allow melted plastic 344 to be injected to the sides of a stack 342 of multiple layers, such that that all areas around the stack 342 are filled with the plastic 344. The selected plastic 344 may have a dielectric strength of about 600 V/micron. When the applied voltage is 1,500 V and the distance 328 between the positive and negative section of the internal layers is as close as 10 microns, the plastic 344 can provide a protection of 6000 V. The stainless steel films 302, 304, 306, 308 can have a thickness of, for example, 12.7 microns, which can provide sufficient stiffness to not bend when the melted plastic 344 is injected. After the layers 342 are injected molded, two of the sides may be water jet cut on the layer cut line 346, 348 of FIG. 5 to expose the plus and minus contacts of the capacitor. Then aluminum end sections may be glued onto the ends with silver filled epoxy adhesive.

A capacitor according to the embodiments disclosed herein can be a solid state polymer based capacitor, where there is no liquid electrolyte. The capacitor can store energy in an electric field with no charging current flow through the capacitor.

The capacitor can be sealed into a plastic (e.g., the injection molded plastic 344 of FIG. 5) that is hydrophobic to prevent or reduce degradation due to moisture. Sealing the capacitor in plastic can also provide excellent resistance to shock and vibration. A capacitor with a large number of layers in the stack will have high capacitance with high voltage and high resistance. The capacitor can be used as a replacement for aluminum electrolytic capacitors, utility grid power factor correction, and photovoltaic voltage smoothing.

The process disclosed herein incorporates the ceramic particles into the polymer matrix. The CMBT particles can provide high insulation resistance and are produced where the relative permittivity (capacitance) increases with applied voltage. The coating that is applied to the CMBT particles can assist in providing a seal that helps to prevent degradation.

Note that not all of the activities described above in the general description or the examples are required, that a portion of a specific activity may not be required, and that one or more further activities may be performed in addition to those described. Still further, the order in which activities are listed is not necessarily the order in which they are performed.

Benefits, other advantages, and solutions to problems have been described above with regard to specific embodiments. However, the benefits, advantages, solutions to problems, and any feature(s) that may cause any benefit, advantage, or solution to occur or become more pronounced are not to be construed as a critical, required, or essential feature of any or all the claims.

The specification and illustrations of the embodiments described herein are intended to provide a general understanding of the structure of the various embodiments. The specification and illustrations are not intended to serve as an exhaustive and comprehensive description of all of the elements and features of apparatus and systems that use the structures or methods described herein. Certain features, that are for clarity, described herein in the context of separate embodiments, may also be provided in combination in a single embodiment. Conversely, various features that are, for brevity, described in the context of a single embodiment, may also be provided separately or in a subcombination. Further, reference to values stated in ranges includes each and every value within that range. Many other embodiments may be apparent to skilled artisans only after reading this specification. Other embodiments may be used and derived from the disclosure, such that a structural substitution, logical substitution, or another change may be made without departing from the scope of the disclosure. Accordingly, the disclosure is to be regarded as illustrative rather than restrictive.

## Claims

1. A capacitor comprising:
a first electrode;
a dielectric layer comprising:
a polymer matrix including epoxy resin; and
ceramic particles dispersed within the polymer matrix and comprising a
composition-modified barium titanate, and
a second electrode, wherein the dielectric layer is disposed between the first
electrode and the second electrode.

2. The capacitor of claim 1, wherein the composition-modified barium titanate comprises (Ba_{1-α-µ-ν}A_{µ}D_{ν}Ca_{α})[Ti_{1-x-δ-µ'-ν'}Mn_{δ}A'_{µ'}D_{ν'}Zrₓ]_{z}O₃, where A=Ag or La, A'=Dy, Er, Ho, Y, Yb, or Ga; D=Nd, Pr, Sm, or Gd; D'=Nb or Mo; 0.10 ≤ x ≤ 0.25; 0 ≤ µ ≤ 0.01, 0 ≤ µ' ≤ 0.01, 0 ≤ ν ≤ 0.01, 0 ≤ ν' ≤ 0.01, 0 ≤ δ ≤ 0.01, 0.995 ≤ z ≤ 1, and 0 ≤ α ≤ 0.05.

3. The capacitor of claim 1, wherein the ceramic particles are coated with an amphiphilic agent.

4. The capacitor of claim 1, wherein the dielectric layer has a thickness in a range of 0.1 microns to 100 microns, or 3 microns to 50 microns, or 3 microns to 30 microns.

5. The capacitor of claim 1, wherein the dielectric layer has a relative permittivity of at least 30, or at least 50.

6. The capacitor of any preceding claim, wherein the ceramic particles make up at least 20 vol%, at least 30 vol%, at least 40 vol%, or at least 50 vol% of a total volume of the polymer matrix and the ceramic particles.

7. The capacitor of any preceding claim, wherein the ceramic particles make up not greater than 95 vol%, no greater than 90 vol%, or no greater than 85 vol% of a total volume of the ceramic particles and the polymer matrix.

8. The capacitor of claims 1 to 5, wherein the ceramic particles make up in a range of 20 vol% to 95 vol%, in a range of 30 vol% to 90 vol%, or in a range of 40 vol% to 85 vol% of a total volume of the ceramic particles and the polymer matrix.

9. A method of forming a capacitor according to any preceding claim, the method comprising:
mixing a polymer precursor solution comprising epoxy resin and ceramic particles comprising a composition-modified barium titanate to form a mixture, whe
rein a volume percent of the ceramic particles to a total volume of the mixture is at least 20%; and
spin coating the mixture onto a substrate to form a dielectric layer on the substrate.

10. The method of claim 9, further comprising curing the mixture.

11. The method of claims 10, wherein the mixture is cured at a temperature in a range of 70 °C to 140 °C.

12. The method of claim 9, wherein spin coating comprises dispensing the mixture on the substrate while the substrate is spinning at a speed in a range of 0 revolutions per minute (rpm) to 500 rpm.

13. The method of claim 12, wherein spin coating further comprises spinning the substrate at a speed in a range of 1000 rpm to 6000 rpm after dispensing the mixture.

14. The method of claim 9, wherein the dielectric layer has a thickness in a range of 0.1 microns to 100 microns.

15. The method of claim 9, wherein the dielectric layer has a relative permittivity of at least 30.
